# EUROPEAN PATENT APPLICATION

(11) **EP 3 379 691 A1**
(43) Date of publication of application: **26.09.2018**
(21) Application number: 17162490.1
(22) Date of filing: 23.03.2017
(51) Int. Cl.: H02J 7/34, H01L 35/32

(54) **THERMO-ELECTRIC GENERATOR SYSTEM, MONITORING SYSTEM THEREFOR, AND METHODS OF DESIGNING AND CONSTRUCTING THEM**

(71) Applicant: The European Union, represented by the European Commission, 1049 Brussels (BE)
(72) Inventor: AVARITSIOTI, Eleni, 19009 RAFINA (GR)
(74) Representative: Gevers Patents

(57) **Abstract**

A thermo-electric generator (TEG) system for charging a battery of voltage X, comprising a plurality of TEGs arranged in an array M defining the TEG system, the array M comprising m strings of TEGs x n TEGs per string. The total of n x V_{TEG} is within a predetermined percentage of a predetermined charging voltage A for charging the battery, where V_{TEG} is the output voltage for each TEG. The charging voltage A is predetermined, based on voltage X, so as to be within respective V-I curves for the battery for two predetermined extremes of ΔT, where ΔT is the temperature difference across the TEGs. The TEG system optionally further comprises a rectifier element (e.g. Zener diode) for connecting the output of the array M to the battery. Also disclosed is a monitoring system for a TEG system (e.g. as aforementioned), the monitoring system comprising a linear current sensor, coupled to the output of the array M, and configured to generate at a current sensor output a first output voltage indicative of the current output by the array M. A voltage comparator has a first input coupled to the current sensor output and a second input coupled to a point at a first threshold voltage. The monitoring system further comprises one or more alert devices, coupled to the output of the voltage comparator and/or to the current sensor output and configured to emit an audible and/or visual alert if the output voltage of the array M drops below the first threshold voltage and/or the current output by the array M drops below a first threshold current. Also disclosed is a method of designing a TEG system, and a method of constructing the TEG system.

## Description

### Technical field

The present invention generally relates to electricity generation systems, and more particularly to a thermo-electric generator (TEG) system, to a monitoring system therefor, and to methods of designing and constructing a TEG system.

### Background Art

Car manufacturers that implement exhaust heat energy recovery have traditionally used the Stirling Engine (e.g. Rankine Cycle) principle in their passenger cars due to the relatively higher cost of TEGs. The fact that the efficiency of TEGs is increasing by the introduction of new thermoelectric materials, as well as their reducing costs (at least for Heavy Duty Vehicles a Total Cost of Ownership (TCO) is now comparable to that of an equivalent Rankine Cycle System) means that TEGs can be considered for energy recovery in an automotive context.

In general, in applications where the temperature difference ΔT across the TEG is not constant, an electronic interface is inserted between the TEG system and the load which continuously tracks the Maximum Power Point (MPP), namely an MPP Tracker (MPPT). This is done in order to maintain the operating point of the TEG at VOC/2 (where VOC is the open circuit voltage) independently of the actual value of ΔT, so that the maximum possible electrical power which can be produced at a given ΔT is delivered to the load.

Heretofore, a number of MPPT algorithms for TEGs have been proposed, namely Perturb & Observe (P&O), Incremental Conductance (INC), the Fractional Open-Circuit Voltage (FOC/FOCV) technique and the Extremum Seeking Control (ESC).

The P&O algorithm is one of the most commonly used techniques due to its simplicity as to the hardware implementation, despite the computational load involved, thanks to the new families of advanced microcontrollers. Examples of P&O techniques include those described in Laird, (2013) "Steady state reliability of maximum power point tracking algorithms used with a thermoelectric generator", Proc. IEEE International Symposium on Circuits and Systems (ISCAS), ISBN:978-1-4673-5760-9, pp.1316-19, and in Paraskevas, A. and Koutroulis, E. (2016) "A maximum power point tracker for thermoelectric generators", Energy Conversion and Management, Vol. 108, pp. 355-65. Examples of INC techniques include those described in Laird, I., Lovatt, H., Savvides, N., Lu, D. and Agelidis, G. V. (2008) "Comparative study of maximum power point tracking algorithms for thermoelectric generators", Proc. of Australasian Universities Power Engineering Conference, pp. 1-6.

The basic operating principle for P&O techniques requires continuously perturbing the electrical operating point and comparing it to the previous value. In this method the operating point moves along the parabola-shaped Power-Voltage curve of the TEG and the maximum value corresponds to maximum power extracted. The classical P&O method, which makes use of a fixed perturbation step and frequency, has a main drawback: when the system is in thermal equilibrium, the electrical operating point oscillates around the MPP. Also, electrical noise must be taken into account when considering reduction of perturbation size and increase of tracking speed.

The INC technique is based on the fact that the slope of the Power-Voltage curve, dP/dV, is zero at the MPP. Also, dP/dI> 0 to the left of the MPP and dP/dl< 0 to its right. As in the P&O algorithm, INC tracks the MPP by perturbing the voltage. (Examples of INC techniques include those described in Laird, I., Lovatt, H., Savvides, N., Lu, D. and Agelidis, G. V. (2008) "Comparative study of maximum power point tracking algorithms for thermoelectric generators", Proc. of Australasian Universities Power Engineering Conference, pp. 1-6.) The difference is that in this case the comparison is made between instantaneous and incremental conductance, instead of comparing previous and current values of output power. However, the main drawback of INC is similar to that of P&O, i.e. when the system is in thermal equilibrium, the electrical operating point oscillates around the MPP.

The FOCV tracking technique utilises the fact that the MPP voltage is at a fixed ratio of the open circuit voltage of a TEG, i.e. Von/2. (Examples of FOC/FOCV techniques include those described in Kim, S., Cho, S., Kim, N. and Park, J. (2010) "A maximum power point tracking circuit of thermoelectric generators without digital controllers", IEICE Electronics Express, Vol. 7 No. 20, pp. 1539-45, and in Montecucco, A. and Knox, A. (2015) "Maximum power point tracking converter based on the open-circuit voltage method for thermoelectric generators", IEEE Transactions on Power Electronics, Vol. 30 No. 2, pp. 828-39.) According to that technique the power transferred to the load is interrupted by disconnecting the TEG from the load and measuring the open circuit voltage. This method has two main drawbacks: during the voltage sampling no power is delivered to the load although the system is in thermal equilibrium, which means that a proper sampling frequency should be selected to reduce power losses to an acceptable level and the need for the inclusion of a customised overvoltage snubber circuit to prevent undesirable voltage oscillations.

ESC is an algorithm which seeks the extremum for steady-state online optimisation without knowledge of the plant model. (Examples of ESC techniques include those described in Phillip, N., Maganga, 0., Burnham, K., Ellis, M., Robinson, S., Dunn, J. and Rouaud, C. (2013) "Investigation of maximum power point tracking for thermoelectric generators", Journal of Electronic Materials, Vol. 42 No.7, pp. 1900-6.) However, it is assumed that measurements of the plant input and output signals are available. This algorithm finds a set point which keeps the output power of the TEG modules at the MPP.

In summary, the first two MPPT algorithms (P&O, INC) require the measurement of both current and voltage and usually present a substantial computational load per Pulse Width Modulation (PWM) period, while the FOC method requires only a voltage reading and has a relatively low computational overhead.

### Technical problem

Consequently, a major challenge, in the design of such TEG systems, is the connection of the TEG system to the load through appropriate electronic circuits that will provide the maximum power available to the load. This, in principle, requires the measurement of parameters such as output current and voltage of the TEG system through the use of sensors, and the use of a MPPT controller that drives a DC-DC (buck-boost) converter. The selection of the appropriate MPPT controller algorithm is important for the overall efficiency, given that the associated DC/DC converter is standardized.

Thus, one problem to be solved is how to provide a design algorithm for the appropriate sizing of the TEG for a given battery type used by any type of exhaust source. A further problem is how to simplify the electronic interface required when the TEG is connected to a battery. A yet further problem is how to provide an electronically simple means of performance monitoring of the TEG system.

### Object of the invention

It is thus an object of the present invention to provide a TEG system that overcomes the abovementioned problems. This is done by the thermo-electric generator (TEG) system as defined in claim 1, by the monitoring system as defined in claim 8, by the method of designing a TEG system as defined in claim 19, and by the method of constructing a TEG system as defined in claim 20.

### General Description of the Invention

According to one aspect of the invention there is provided a thermo-electric generator (TEG) system for charging a battery of voltage X, comprising: a plurality of TEGs arranged in an array M defining the TEG system, the array M comprising m strings of TEGs x n TEGs per string; wherein the total of n x V_{TEG} is within a predetermined percentage of a predetermined charging voltage A for charging the battery, where V_{TEG} is the output voltage for each TEG; wherein charging voltage A is predetermined, based on voltage X, so as to be within respective V-I curves for the battery for two predetermined extremes of ΔT, where ΔT is the temperature difference across the TEGs; and an optional rectifier element for connecting the output of the array M to the battery.

Preferably, the rectifier element comprises a first Zener diode.

In one embodiment, the two predetermined extremes of ΔT are 100 degrees C and 170 degrees C respectively.

Preferably, n lies in the range 2 to 10, more preferably in the range 3 to 5, and more preferably is 4.

Preferably, m lies in the range 5 to 30, more preferably in the range 10 to 20, and more preferably is 15.

Preferably, the predetermined percentage lies in the range 5 to 15, more preferably in the range 8 to 12, and more preferably is 10.

In one embodiment, the TEG system is configured to operate at an efficiency in the range 91-99%.

According to another aspect of the invention there is provided a monitoring system for a TEG system, the TEG system being configured for charging a battery and comprising a plurality of TEGs arranged in a two-dimensional array M, the monitoring system comprising: a linear current sensor, coupled to the output of the array M, and configured to generate at a current sensor output a first output voltage indicative of the current output by the array M; a voltage comparator having a first input coupled to the current sensor output and a second input coupled to a point at a first threshold voltage; and one or more alert devices, coupled to the output of the voltage comparator and/or to the current sensor output and configured to emit an audible and/or visual alert if the output voltage of the array M drops below the first threshold voltage and/or the current output by the array M drops below a first threshold current.

Preferably, the TEG system comprises a TEG system according to any of claims 1 to 7 of the appended claims, or to any of the particular embodiments described herein.

Preferably, the linear current sensor comprises a shunt resistor coupled to the output of the array M. Preferably, the shunt resistor is coupled between the output of the array M and the first Zener diode.

Preferably, the linear current sensor comprises a differential amplifier whose inputs are coupled across the shunt resistor. Preferably, the linear current sensor comprises an adjustment device, coupled to the output of the differential amplifier, for providing an adjusted voltage to the first input of the voltage comparator. Preferably, the adjustment device comprises a variable resistor having opposing terminals connected to the output of the differential amplifier and to ground, and having its tap coupled to the first input of the voltage comparator.

In one embodiment, the point at a first threshold voltage is provided by (i) a second Zener diode, having a rated voltage equal to the first threshold voltage, coupled between ground and the point, and (ii) a first biasing resistor coupled between a regulated voltage level and the point.

The monitoring system preferably further comprises a voltage regulator, coupled to the output of the TEG system, for providing a regulated voltage level.

The monitoring system preferably further comprises a voltmeter coupled between ground and the output of the voltage comparator, and a second biasing resistor coupled between the regulated voltage level and the output of the voltage comparator, wherein the voltmeter is configured to give a continuous reading of the current delivered by the TEG system.

Preferably, the one or more alert devices comprise (i) a visual alert device, for example an LED, coupled between the regulated voltage level and the output of the voltage comparator, and/or (ii) an audible alert device, for example a buzzer, coupled between the regulated voltage level and the output of the voltage comparator.

According to another aspect of the invention there is provided a method of designing a TEG system for charging a battery of voltage X, the method comprising: constructing, for two extremes of ΔT, respective V-I curves for the battery, where ΔT is the temperature difference across the TEGs; determining, based on voltage X, a charging voltage A for charging the battery with the TEG system, where the charging voltage A is within the two curves; determining, based on the determined charging voltage A and the V-I curves, the dimensions of an array M defining the TEG system, comprising m strings of TEGs x *n* TEGs per string; wherein the total of n x V_{TEG} is within a predetermined percentage of a charging voltage A for charging the battery, where V_{TEG} is the output voltage for each TEG.

According to another aspect of the invention there is provided a method of constructing a TEG system for charging a battery of voltage X, comprising: performing the method of claim 19 of the appended claims, or of any of the particular embodiments described herein; and constructing a TEG system comprising the array M of TEGs, optionally further comprising a Zener diode for connecting the output of the array M to the battery.

According to another aspect of the invention there is provided a recordable, rewritable or storable medium having recorded or stored thereon data defining or transformable into instructions for execution by processing circuitry and corresponding to at least the steps of claims 19 and 20 of the appended claims, or to any of the particular embodiments described herein.

A server computer incorporating a communications device and a memory device and being adapted for transmission on demand or otherwise of data defining or transformable into instructions for execution by processing circuitry and corresponding to at least the steps of claims 19 and 20 of the appended claims, or to any of the particular embodiments described herein.

An advantage of the invention is that, at least in embodiments, it affords the implementation of a TEG system that is inexpensive, more reliable and with an overall efficiency between 91% and 99%.

A further advantage of the invention is that it enables very efficient direct connection of the TEG system to a battery, including to prevent battery discharge through the TEG system at low temperature differentials (e.g. when ΔT <70°C).

### Brief Description of the Drawings

Further details and advantages of the present invention will be apparent from the following detailed description of several not limiting embodiments with reference to the attached drawings, wherein:
- Figure 1: illustrates the relationship between a battery load and the TEG output, showing (a) I-V plots for each of nominal battery voltage for 3 different states of charge (SoC) and TEG output for five different values of ΔT, and (b) a schematic view of a power source connected for charging a battery;
- Figure 2: shows plots of battery voltage versus battery SoC, for a lead acid battery and for 4 voltage values - C/5, C/10, C/20 and C/40 - where C is the total open circuit voltage of the (n) TEGs (modules) connected in series, indicating intersection points for SoC=20% and SoC=100%;
- Figure 3: shows curves for battery current plotted against battery voltage, for the two values of SoC in Fig.2;
- Figure 4: shows plots of charging current against voltage, with the I=V plots at different values of ΔT from Fig. 1(a) superimposed on the two curves of Fig. 3;
- Figure 5: is a flowchart of a process used in the construction, according to an embodiment of the invention, of a TEG system comprising an array M of m strings, with n TEGs per string;
- Figure 6: shows a TEG system according to an embodiment of the invention, for example constructed using the process of Fig. 5 and connected for charging a battery; and
- Figure 7: illustrates a TEG system according to an embodiment of the invention, connected for charging a battery and coupled to a monitoring system according to an embodiment of the invention.

### Description of Preferred Embodiments

In the description and drawings, like numerals are used to designate like elements. Unless indicated otherwise, any individual design feature, component or step may be used in combination with any other design features, components or steps disclosed herein.

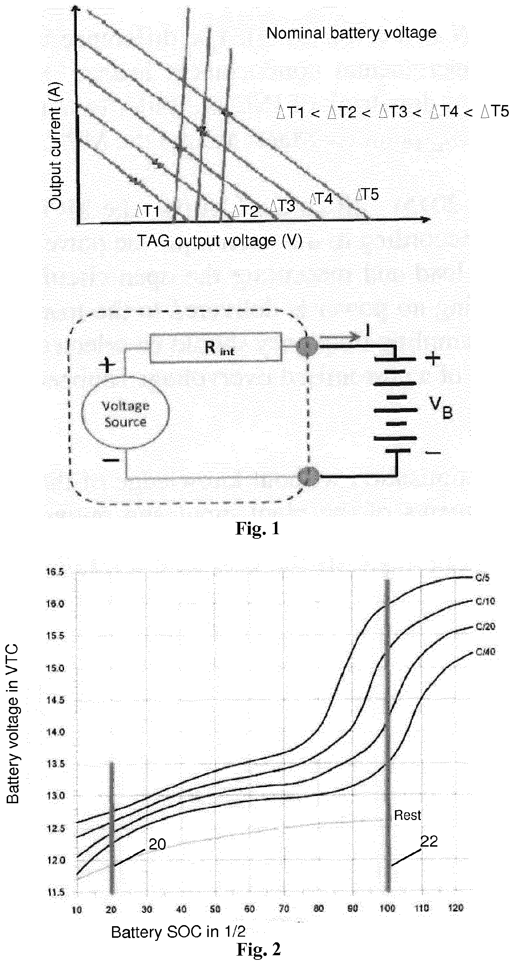

Figure 1(a) illustrates the relationship between a battery load and the TEG output, showing (a) I-V plots for each of nominal battery voltage for 3 different states of charge (SoC) and TEG output for five different values of ΔT. (As is well known, a power source such as a TEG 10 may be considered as a voltage source 12 connected in series with an internal resistance 14, when coupled for charging a battery 16, as shown in Fig. 1(b).)

When a TEG is connected to a battery, the output voltage of the TEG is fixed by the battery voltage. The placement of a power diode in series between TEG and battery (with a penalty of a voltage drop of typically not more than 0.7V) prevents the battery discharge through the TEG when the temperature difference ΔT across it is zero. Figure 1 shows the relationship between a battery load and the TEG output. The five lines correspond (left to right) to ΔT₁, ΔT₂, ΔT₃, ΔT₄, and ΔT₅, where ΔT₁ < ΔT₂ < ΔT₃ < ΔT₄ < ΔT₅.

Figure 1(a) implies that the operating point of such a system corresponds to the intersection of the two lines, i.e. the I-V line of TEG at a given ΔT and the I-V line of the battery at a given SoC.

It is well known that the electrical power produced by a TEG varies, depending on the electrical load connected at the TEG terminals, and that the maximum power is achieved in the centre of the I-V lines, when the voltage is half of the open-circuit voltage *V*_{oc} or likewise when the current drawn is half of the short-circuit current *I*_{sc}. In accordance with embodiments of the invention, the object is for a given battery, to design the appropriate TEG system (i.e. modules connected in series and in parallel) so that most of its Voc/2 points are laying between two predefined I-V curves of the battery.

Figure 2 shows plots of battery voltage versus battery SoC, for a lead acid battery and for 4 voltage values - C/5, C/10, C/20 and C/40 - where C is the total open circuit voltage of the (n) TEGs (modules) connected in series. The plots indicate intersection points for SoC=20% and SoC=100%. Assuming, for the sake of simplicity that a 12V/100Ah lead acid battery is used, one can derive the I-V characteristics at any SoC from the charging curves shown in Fig. 2 for lead-acid batteries. For the purpose of TEG system construction, the two I-V curves chosen correspond to two values of SoC, i.e. 20% (line 20) and 100% (line 22), respectively.

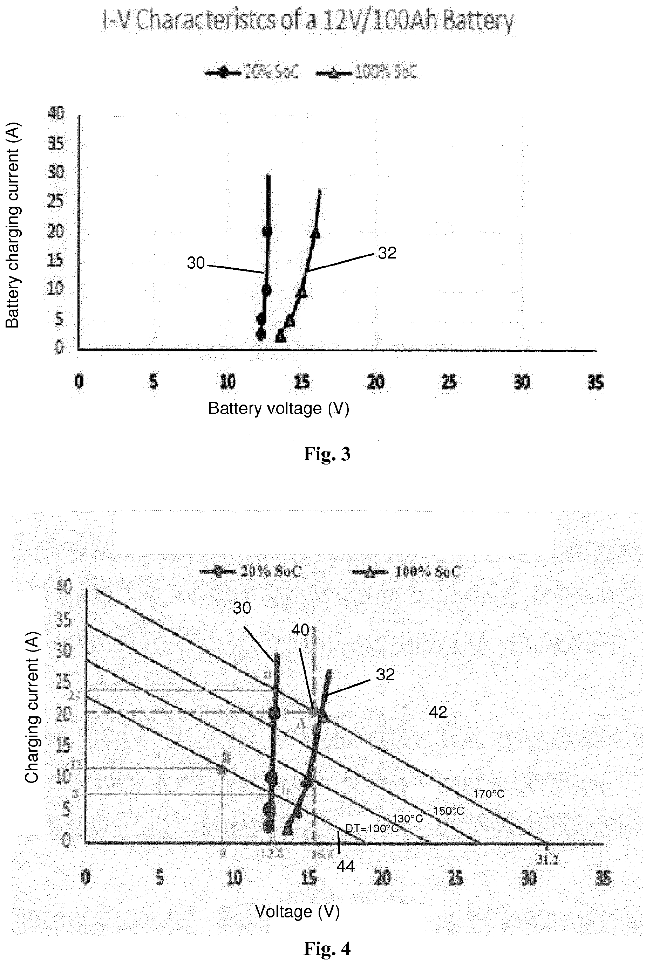

Figure 3 shows curves for battery current plotted against battery voltage, for the two values of SoC in Fig.2. In this example, the characteristics are for a 22V / 100Ah battery. Thus, there are shown a curve 30 for 20% SoC and a curve 32 for 100% SoC.

For the present embodiment, TEG system is designed so that its MPPs lay between the two battery curves of Fig. 3, and when its temperature differentials vary between 100°C and 170°C.

Figure 4 shows plots of charging current against voltage, with the I=V plots at different values of ΔT from Fig. 1(a) superimposed on the two curves 30, 32 of Fig. 3. Thus, in the construction of the TEG system, a voltage (A) - indicated by point 40 - suitable to charge the battery is selected so as be within the two extreme curves 30, 32 shown in Fig. 4. Suitably, the line 42 corresponds to AT=170 degrees C, and line 44 corresponds to AT=100 degrees C.

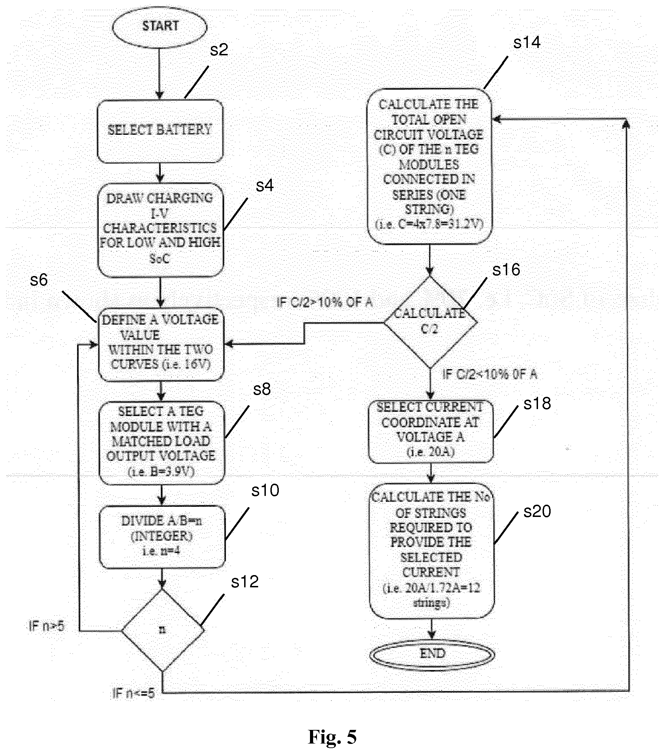

The above step is used in the process of Fig. 5. More generally, Fig.5 is a flowchart of a process used in the construction, according to an embodiment of the invention, of a TEG system comprising an array M of m strings, with n TEGs per string.

First, a battery to be charged is provided/selected (step s2). Next, the charging I-V characteristics (curves) 30, 32 for low (20%) and high (100%) SoC are drawn (step s4), as described above with reference to Fig. 3. The voltage value (A) within the two curves 30, 32 is then defined, at step s6, as described above with reference to Fig. 4. For the sake of the paradigm, and for illustration, the voltage A selected is 16V.

At step s8, a techno-economically suitable TEG module is selected which, when connected in series (i.e. in strings) with similar ones, will attain that voltage (16V). In this example, the TEG module is a GM200-127-14-10 available off-the-shelf TEG from European Thermodynamics Ltd, and this has an output voltage (B) of 3.9V. Dividing A by B at step s10 and taking the integer values gives a value for n of 4.

A test is made at step s12: if it is determined that n is greater than 5, processing returns to step s6 for reselection/redefinition of the voltage A. If, on the other hand, it is determined at step s12 that n ≤ 5, the process continues to step s14, where the total open circuit voltage (C) of the n TEG modules (@ 3.9V each) connected in series, i.e. one string, is calculated.

It is worth noting that as the number of modules required to be connected in series (string) in order to achieve a voltage is increased, the internal resistance of the string increases resulting to internal power losses. So, the number, n, of modules connected in series must be the minimum possible one. In the present embodiment, n=4.

According to the process of Fig. 5, four of the selected TEG modules connected in series (a string) will provide the required voltage. The open circuit voltage of the string of the 4 modules is Voc= 31.2V and Voc/2=15.6V is a value which is very close to the 16V selected. This MPP of the string corresponds to ΔT = 170C.

Next, at step s16, the value C/2 is calculated and compared with the voltage value A. If C/2 is greater than a predetermined percentage of A, processing returns to step s6 for reselection/redefinition of the voltage A. (In this embodiment, the predetermined percentage is 10%.) If, on the other hand, it is determined at step s16 that C/2 ≤ the predetermined percentage of A, the process continues to step s18, where a current coordinate at voltage A in Fig. 4 is selected, to obtain the corresponding (maximum) current (I). In this embodiment, a current of 20A is thus selected as maximum capability of the TEG system.

The process continues at step s20, where the number of strings required to provide the selected current is calculated. Here, in order to achieve this with the selected TEG modules, 15 strings (25A/1.72Az 15) are required to be connected in parallel. Consequently, 60 modules (15 strings x 4 TEGs per string) constitute the final TEG system. Given that the surface area of each module is 40mmX40mm, the total surface area of the derived TEG system is about 0.01m².

From Fig. 4 it is apparent that when the battery is almost discharged (20% SoC) and the temperature difference ΔT is 170°C (point a in Fig. 4), the power delivered to the battery is 307W (24Ax12.8V) instead of 328W (21Ax15.6V) corresponding to the MPP, i.e. an efficiency of 307/328=94%, whereas when the battery is fully charged, the efficiency is almost 99%.

In the case the battery is almost discharged (20% SoC) and the temperature difference of the TEG is 100°C (point b in Fig. 4), the power delivered to the battery is 102W (8Ax12.8V) instead of 108W (12Ax9V) which corresponds to point B (the MPP for 100°C), resulting to an efficiency of 102/108=94%, whereas when the battery is fully charged, the efficiency is more than 91%.

Thus, in this embodiment, it is noted that the range of efficiency that can be achieved (i.e. 91% to 99%) is comparable to sophisticated MPP controllers found in conventional systems.

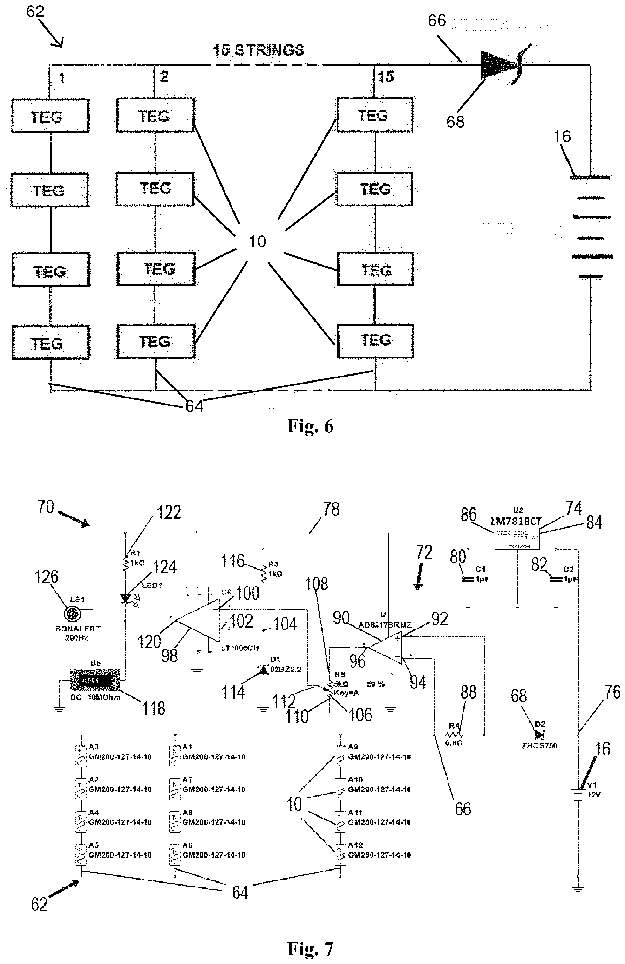

Figure 6 shows a TEG system 62 according to an embodiment of the invention, for example constructed using the process of Fig. 5 and connected for charging a battery 16, in this example a 12V / 100Ah battery). The TEG system 62 comprises a plurality of strings 64 (in this embodiment, 15, not all of which are shown). Within each string 64, there are a plurality of TEGs 10 (in this embodiment, 4) connected in series. The output 66 of the TEG system 62 is, in use, preferably connected to battery 16 via a rectifier element, in this embodiment Zener diode 58. The latter is suitably a SD51 Schottky rectifier, offered by International Rectifier. This device has the following characteristics.

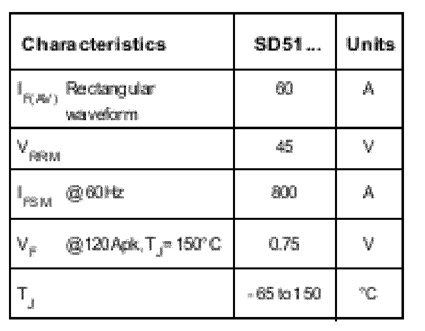

It will be appreciated by persons skilled in the art, however, that rectifier elements with similar characteristics to the above may be used.

It is apparent that the process of Fig. 5, for the sizing of the TEG system 62 in relation to the I-V characteristics of a given battery 16, allows for its very efficient direct connection, through for example a Zener diode 68, to prevent battery discharge through the TEG system when ΔT<70°C, as shown in Fig. 6.

Figure 7 illustrates a TEG system 62 according to an embodiment of the invention, connected for charging a battery 16 and coupled to a monitoring system 70 according to an embodiment of the invention.

The monitoring system 70 is configured to monitor the performance of the TEG system 62, by monitoring the current (or current and voltage) provided by the TEG system 62, e.g. during truck hauling. The system may be configured such that when, during truck hauling, the voltage, indicated on a voltmeter, drops below 2.2V, an undesired condition has occurred with the TEG system, and action is to be taken, as described further below.

In this embodiment, the monitoring system 70 incudes a linear current sensor, generally designated 72.

In addition, this embodiment includes a voltage regulator 74, coupled to the output of the TEG system 62; that is, coupled to the output 76 of (first) Zener diode 68, for providing a regulated voltage level on line voltage source 78. Filtering capacitors 80 and 82 are connected between ground and each of the V_{REG} input 84 and LINE VOLTAGE output 86 of voltage regulator 74. Voltage regulator 74 suitably comprises a 3-Term 1A, Positive Voltage, Linear Voltage Regulator, such as a LM 7818CT, manufactured by Fairchild Semiconductor.

Returning to the linear current sensor 72, this comprises a shunt resistor 88 coupled to the output 66 of (the array M of) the TEG system 62, the voltage across shunt resistor 88 corresponding linearly to the (charging) current flowing from TEG system 62 to battery 16. Thus, shunt resistor 88 is coupled between the output 66 of (the array M of) the TEG system 62 and Zener diode 68.

Preferably, the linear current sensor comprises a differential amplifier 90 whose inputs 92, 94 are coupled across the shunt resistor 88. Accordingly, the output 96 of differential amplifier 90 provides an amplified output voltage corresponding to the (charging) current flowing through shunt resistor 88.

The monitoring system 62 preferably further includes a voltage comparator 98 having a first input 100 (indirectly) coupled to the (current sensor) output 96 of differential amplifier 90 and a second input 102 coupled to a point 104 at a first threshold voltage, as will be described in more detail below.

In this embodiment, the linear current sensor 72 comprises an adjustment device, coupled to the output of the differential amplifier 90, for providing an adjusted voltage to the first input of the voltage comparator. More preferably, the adjustment device comprises a variable resistor 106 having opposing terminals 108, 110 connected to the output 96 of the differential amplifier and to ground, and having its tap 112 coupled to the first input 100 of the voltage comparator 98.

Also in accordance with this embodiment, the point 104 at a first threshold voltage is provided by a (second) Zener diode 114, having (i) a rated voltage equal to the first threshold voltage, coupled between ground and the point 104, and (ii) a first biasing resistor 116 coupled between the regulated voltage level (line voltage source 78) and the point 104. In this case, the (second) Zener diode 114 is rated such that the first threshold voltage is 2.2V, and so as to maintain point 104 thereat.

In this embodiment, the monitoring system 62 further comprises a voltmeter 118 coupled between ground and the output 120 of the voltage comparator 98. A second biasing resistor 122 is coupled between the line voltage source 78 and the output 120 of the voltage comparator 98. In use, the voltmeter 118 is configured to give a continuous reading of the current delivered by the TEG system 62.

The monitoring system 70 preferably includes one or more alert devices. These may include a visual alert device, for example an LED 124 (in series with second biasing resistor 122), coupled between the line voltage source 78 and the output of the voltage comparator 98. The one or more alert devices may also include an audible alert device, for example a buzzer 126, coupled between the line voltage source 78 and the output 120 of the voltage comparator 98.

Thus, in this embodiment, monitoring system 70 is configured to generate both an optical and an acoustic alert when the voltage sensed by the comparator 98 drops below 2.2 Volts. This predetermined voltage can be changed simply by substituting Zener diode 114 by another one of different Zener voltage.

Also, as mentioned, voltmeter 118 gives a continuous reading of the current delivered by the TEG system 62 to the battery 16, and LED 124 lights-on and/or buzzer 126 sounds, when the current passing through shunt resistor 88 reduces below 2.5 A.

While embodiments have been described by reference to embodiments of survey devices having various components in their respective implementations, it will be appreciated that other embodiments make use of other combinations and permutations of these and other components.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the above description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the Detailed Description are hereby expressly incorporated into this Detailed Description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those skilled in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

As used herein, unless otherwise specified, the use of the ordinal adjectives "first", "second", "third", etc., to describe a common object, merely indicate that different instances of like objects are being referred to, and are not intended to imply that the objects so described must be in a given sequence, either temporally, spatially, in ranking, or in any other manner.

All publications, patents, and patent applications cited herein are hereby incorporated by reference.

Any discussion of prior art in this specification should in no way be considered an admission that such prior art is widely known, is publicly known, or forms part of the general knowledge in the field.

In the claims below and the description herein, any one of the terms "comprising", "comprised of" or "which comprises" is an open term that means including at least the elements/features that follow, but not excluding others. Thus, the term "comprising", when used in the claims, should not be interpreted as being limitative to the means or elements or steps listed thereafter. For example, the scope of the expression "a device comprising A and B" should not be limited to devices consisting only of elements A and B. Any one of the terms "including" or "which includes" or "that includes" as used herein is also an open term that also means including at least the elements/features that follow the term, but not excluding others. Thus, "including" is synonymous with and means "comprising".

Similarly, it is to be noticed that the term "coupled", when used in the claims, should not be interpreted as being limitative to direct connections only. The terms "coupled" and "connected," along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other. For example, in the context of airflow, where an outlet of A is coupled to an inlet of B, it may be that one or more additional devices are provided between the outlet of A and the inlet of B.

Thus, while there has been described what are believed to be the preferred embodiments of the invention, those skilled in the art will recognize that other and further modifications may be made thereto without departing from the scope of the invention, and it is intended to claim all such changes and modifications as fall within the scope of the invention. For example, any formulas given above are merely representative of procedures that may be used. Functionality may be added or deleted from the block diagrams and operations may be interchanged among functional blocks. Steps may be added or deleted to methods described within the scope of the present invention.

### Legend:

- 10: TEG
- 12: voltage source
- 14: internal resistance
- 16: battery
- 30: curve
- 32: curve
- 40: point
- 42: line
- 44: line
- 58: Zener diode
- 62: TEG system / monitoring system
- 64: strings
- 66: output
- 68: Zener diode
- 70: monitoring system
- 72: linear current sensor
- 74: voltage regulator
- 76: output
- 78: line voltage source
- 80: filtering capacitor
- 82: filtering capacitor
- 84: V_{REG} input
- 86: LINE VOLTAGE output
- 88: shunt resistor
- 90: differential amplifier
- 92: input
- 94: input
- 96: output
- 98: voltage comparator
- 100: input
- 102: input
- 104: point
- 106: variable resistor
- 108: terminal
- 110: terminal
- 112: tap
- 114: Zener diode
- 116: biasing resistor
- 118: voltmeter
- 120: output
- 122: biasing resistor
- 124: LED
- 126: buzzer

## Claims

1. A thermo-electric generator (TEG) system for charging a battery of voltage X, comprising:
a plurality of TEGs arranged in an array M defining the TEG system, the array M comprising m strings of TEGs x n TEGs per string;
wherein the total of n x V_{TEG} is within a predetermined percentage of a predetermined charging voltage A for charging the battery, where V_{TEG} is the output voltage for each TEG;
wherein charging voltage A is predetermined, based on voltage X, so as to be within respective V-I curves for the battery for two predetermined extremes of ΔT, where ΔT is the temperature difference across the TEGs; and
an optional rectifier element for connecting the output of the array M to the battery.

2. A TEG system according to claim 1, wherein the rectifier element comprises a first Zener diode.

3. A TEG system according to claim 1 or 2, wherein the two predetermined extremes of ΔT are 100 degrees C and 170 degrees C respectively.

4. A TEG system according to claim 1, 2 or 3, wherein n lies in the range 2 to 10, more preferably in the range 3 to 5, and more preferably is 4.

5. A TEG system according to any of the preceding claims, wherein m lies in the range 5 to 30, more preferably in the range 10 to 20, and more preferably is 15.

6. A TEG system according to any of the preceding claims, wherein the predetermined percentage lies in the range 5 to 15, more preferably in the range 8 to 12, and more preferably is 10.

7. A TEG system according to any of the preceding claims, configured to operate at an efficiency in the range 91-99%.

8. A monitoring system for a TEG system, the TEG system being configured for charging a battery and comprising a plurality of TEGs arranged in a two-dimensional array M, the monitoring system comprising:
a linear current sensor, coupled to the output of the array M, and configured to generate at a current sensor output a first output voltage indicative of the current output by the array M;
a voltage comparator having a first input coupled to the current sensor output and a second input coupled to a point at a first threshold voltage; and
one or more alert devices, coupled to the output of the voltage comparator and/or to the current sensor output and configured to emit an audible and/or visual alert if the output voltage of the array M drops below the first threshold voltage and/or the current output by the array M drops below a first threshold current.

9. A monitoring system according to claim 8, wherein the TEG system comprises a TEG system according to any of claims 1 to 7.

10. A monitoring system according to claim 8 or 9, wherein the linear current sensor comprises a shunt resistor coupled to the output of the array M.

11. A monitoring system according to claim 10, when dependent upon claim 9, wherein the shunt resistor is coupled between the output of the array M and the first Zener diode.

12. A monitoring system according to claim 10 or 11, wherein the linear current sensor comprises a differential amplifier whose inputs are coupled across the shunt resistor.

13. A monitoring system according to claim 12, wherein the linear current sensor comprises an adjustment device, coupled to the output of the differential amplifier, for providing an adjusted voltage to the first input of the voltage comparator.

14. A monitoring system according to claim 13, wherein the adjustment device comprises a variable resistor having opposing terminals connected to the output of the differential amplifier and to ground, and having its tap coupled to the first input of the voltage comparator.

15. A monitoring system according to any of claims 8 to 14, wherein the point at a first threshold voltage is provided by (i) a second Zener diode, having a rated voltage equal to the first threshold voltage, coupled between ground and the point, and (ii) a first biasing resistor coupled between a regulated voltage level and the point.

16. A monitoring system according to any of claims 8 to 15, further comprising a voltage regulator, coupled to the output of the TEG system, for providing a regulated voltage level.

17. A monitoring system according to claim 16, further comprising a voltmeter coupled between ground and the output of the voltage comparator, and a second biasing resistor coupled between the regulated voltage level and the output of the voltage comparator, wherein the voltmeter (U5) is configured to give a continuous reading of the current delivered by the TEG system.

18. A monitoring system according to claim 16 or 17, wherein the one or more alert devices comprise (i) a visual alert device, for example an LED, coupled between the regulated voltage level and the output of the voltage comparator, and/or (ii) an audible alert device, for example a buzzer, coupled between the regulated voltage level and the output of the voltage comparator.

19. A method of designing a TEG system for charging a battery of voltage X, the method comprising:
constructing, for two extremes of ΔT, respective V-I curves for the battery, where ΔT is the temperature difference across the TEGs;
determining, based on voltage X, a charging voltage A for charging the battery with the TEG system, where the charging voltage A is within the two curves;
determining, based on the determined charging voltage A and the V-I curves, the dimensions of an array M defining the TEG system, comprising m strings of TEGs x *n* TEGs per string;
wherein the total of n x V_{TEG} is within a predetermined percentage of a charging voltage A for charging the battery, where V_{TEG} is the output voltage for each TEG.

20. A method of constructing a TEG system for charging a battery of voltage X, comprising:
performing the method of claim 19; and
constructing a TEG system comprising the array M of TEGs, optionally further comprising a Zener diode for connecting the output of the array M to the battery.

21. A recordable, rewritable or storable medium having recorded or stored thereon data defining or transformable into instructions for execution by processing circuitry and corresponding to at least the steps of claims 19 and 20.

22. A server computer incorporating a communications device and a memory device and being adapted for transmission on demand or otherwise of data defining or transformable into instructions for execution by processing circuitry and corresponding to at least the steps of claims 19 and 20.
